# EUROPEAN PATENT APPLICATION

(11) **EP 4 553 899 A1**
(43) Date of publication of application: **14.05.2025**
(21) Application number: 24211867.7
(22) Date of filing: 08.11.2024
(51) Int. Cl.: H01L 25/065, H01L 23/00, H01L 25/00, H10D 62/10

(54) **DIE IN DIE SEMICONDUCTOR DEVICE AND METHOD THEREFOR**

(30) Priority: 09.11.2023 US 202318505364
(71) Applicant: NXP B.V., 5656 AG Eindhoven (NL)
(72) Inventor: LIN, Yen-Chih, 5656AG Eindhoven (NL); TSAI, YI-Hsuan, 5656AG Eindhoven (NL); TSAI, YU LING, 5656AG Eindhoven (NL); CHANG, Yao Jung, 5656AG Eindhoven (NL)
(74) Representative: Hardingham, Christopher Mark

(57) **Abstract**

A method of forming a die-in-die semiconductor device is provided. The method includes forming a first cavity in a backside of a first semiconductor die. The first semiconductor die has a back end of line (BEOL) region, a front end of line (FEOL) region, and a bulk region. A second semiconductor die is mounted in the first cavity. A bond pad of the second semiconductor die is interconnected through a bottom side of the first cavity with an embedded conductive trace of the BEOL region of the first semiconductor die.

## Description

### Background

### Field

This disclosure relates generally to semiconductor device packaging, and more specifically, to a die-in-die semiconductor device and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. With such features and applications, the configuration of the semiconductor device packages may limit performance of the semiconductor devices or impact the costs of the semiconductor devices. Accordingly, significant challenges exist in accommodating these features and applications while minimizing the impact on semiconductor devices' performance and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified top-side-up plan view, an example die-in-die semiconductor device at a stage of manufacture in accordance with an embodiment.
FIG. 2 through FIG. 8 illustrate, in simplified cross-sectional views, the example die-in-die semiconductor device taken along line A-A of FIG. 1 at various stages of manufacture in accordance with an embodiment.

### Detailed Description

Generally, there is provided, a die-in-die semiconductor device. The die-in-die semiconductor device includes a first semiconductor die and a second semiconductor die interconnected with the first semiconductor through a backside of the first semiconductor die. A first cavity is formed in the backside of the first semiconductor die. The first cavity has width, length, and depth dimensions sufficient for mounting the second semiconductor die at least partially within the first cavity. A plurality of second cavities is formed in the backside of the first semiconductor die and begin at the bottom side of the first cavity, extend vertically through a front end of line region, and end at embedded die interconnect traces of a back end of line region. A portion of the die interconnect traces are exposed at the bottom of the second cavities. After forming the second cavities, a thermal compression non-conductive paste material (e.g., commonly used in flip-chip packaging) is dispensed at the bottom side of the first cavity such that the second cavities are filled, and the bottom of the first cavity is covered. The second semiconductor die includes a plurality of copper pillar affixed to respective bond pads of the second semiconductor die. The second semiconductor die with copper pillars is inserted into the first cavity with a thermal compressive force such that the copper pillars are pushed into respective second cavities. With the copper pillars pushed into respective cavities, the thermal compression non-conductive paste material is displaced, and conductive connections are formed with the respective die interconnect traces of the first semiconductor die. With the thermal compression non-conductive paste material cured, a hermetic seal is formed in the first cavity between the second semiconductor die and the first semiconductor die. By forming the die-in-die semiconductor device in this manner, a compact interconnect, low-profile stacked die arrangement may be realized.

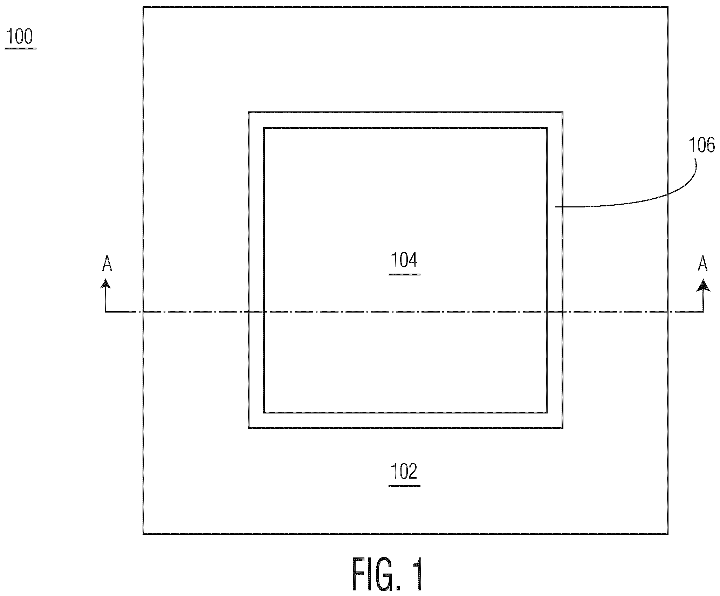

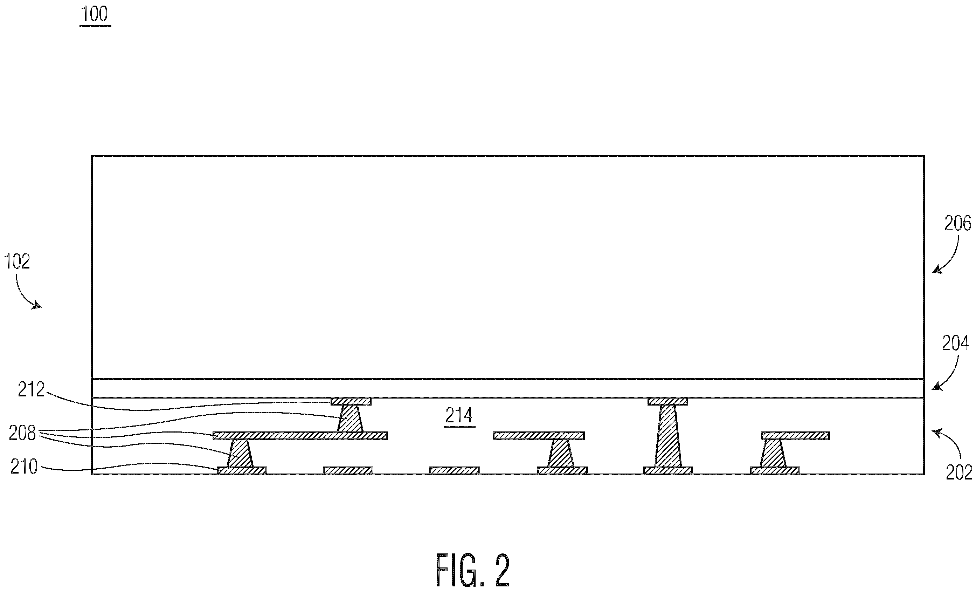

FIG. 1 illustrates, in a simplified top-side-up plan view, an example die-in-die semiconductor device 100 in accordance with an embodiment. At this stage, the semiconductor device 100 includes a first semiconductor die 102, a first cavity 106 formed in a backside of the first semiconductor die, and a second semiconductor die 104 mounted to the first semiconductor die within the cavity. As depicted in FIG. 1, each of the first semiconductor die 102 and the second semiconductor die 104 is arranged in an active-side-down orientation. In this embodiment, the second semiconductor die 104 is interconnected through a bottom side of the first cavity 106 with one or more embedded conductive traces (not shown) of the back end of line (BEOL) region (not shown) of the first semiconductor die 102. The term "conductive," as used herein, generally refers to electrical conductivity unless otherwise described. By mounting and interconnecting the second semiconductor die 104 in this manner, a low-profile die-in-die stacked die arrangement may be realized, for example. With the second semiconductor die 104 mounted to the first semiconductor die 102, a gap separates sidewalls of the second semiconductor die 104 from sidewalls of the first cavity 106. The size, shape, and location of the first cavity 106 within the backside of the first semiconductor die 102 depicted in FIG. 1 are chosen for illustration purposes. Cross-sectional views of examples of the die-in-die semiconductor device 100 taken along line A-A of FIG. 1 at various stages of manufacture are depicted in FIG. 2 through FIG. 8.

FIG. 2 illustrates, in a simplified cross-sectional view, the example die-in-die semiconductor device 100 at a stage of manufacture in accordance with an embodiment. At this stage, the semiconductor device 100 includes the first semiconductor die 102. The first semiconductor die 102 has an active side (e.g., major side having circuitry, bond pads) and a backside (e.g., major side opposite of the active surface). In this embodiment, the semiconductor die 102 is configured in a flip-chip (e.g., active-side-down) orientation. The BEOL region 202 and a front end of line (FEOL) region 204 are formed at the active side of the first semiconductor die 102. The FEOL region 204 generally includes the transistors process layers (e.g., gate, drain, source) and the BEOL region generally includes interconnection metal traces formed in subsequent process layers. A bulk region 206 generally includes the remaining bulk substrate portion of the first semiconductor die 102.

In this embodiment, the BEOL region 202 includes conductive features such as embedded interconnecting metal traces and vias 208, die interconnect traces 212, and connector pads 210 separated by dielectric material 214. The die interconnect traces 212 are configured to be exposed from the backside of the die and interconnected with the second semiconductor die 104 at subsequent stages of manufacture. The connector pads 210 are configured to be exposed at the active side of the die and have a plurality of conductive package connectors affixed at a subsequent stage of manufacture. The arrangement, location, and number of conductive features of the BEOL region 202 of the first semiconductor die 102 depicted in FIG. 2 are chosen for illustration purposes.

The first semiconductor die 102 may be formed from any suitable semiconductor material, such as silicon, germanium, gallium arsenide, gallium nitride, and the like. The first semiconductor die 102 may further include digital circuits, analog circuits, RF circuits, power circuits, memory, processor, MEMS, sensor, the like, and combinations thereof integrated at the active side.

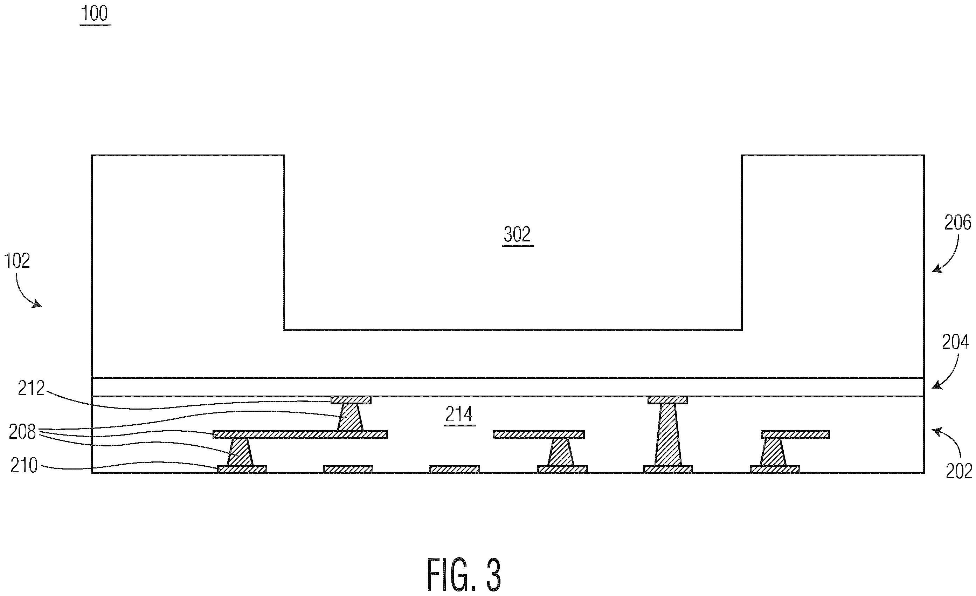

FIG. 3 illustrates, in a simplified cross-sectional view, the example die-in-die semiconductor device 100 at a subsequent stage of manufacture in accordance with an embodiment. At this stage, the semiconductor device 100 includes a first cavity 302 formed in the backside of the semiconductor die 102. The cavity 302 may be etched by way of one or more suitable etch processes, for example. The cavity 302 is formed to have predetermined width, length, and depth dimensions. The predetermined width, length, and depth dimensions of the cavity 302 are chosen to accommodate a second semiconductor die or other component to be mounted within the cavity at a subsequent stage of manufacture. In this embodiment, a portion of the bulk region 206 remains between a bottom side of the cavity 302 and the FEOL region 204. For example, after forming the cavity 302, the portion of the bulk region 206 remaining between the bottom of the cavity 302 and the FEOL region 204 may have a thickness approximately in a range of 30 to 50 microns.

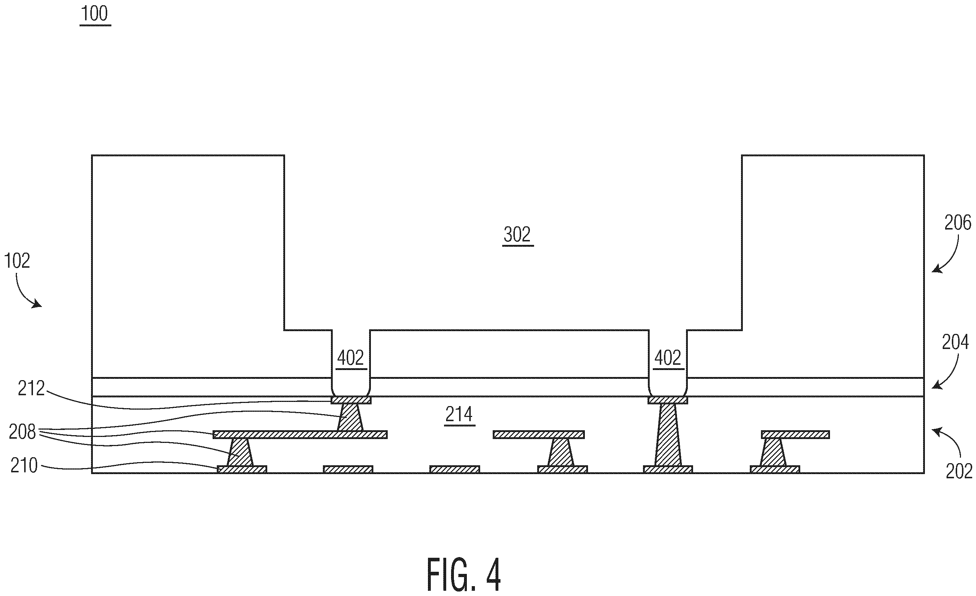

FIG. 4 illustrates, in a simplified cross-sectional view, the example die-in-die semiconductor device 100 at a subsequent stage of manufacture in accordance with an embodiment. At this stage, the semiconductor device 100 includes a plurality of second cavities 402 formed in the backside of the semiconductor die 102. The second cavities 402 are formed beginning at the bottom side of the first cavity 303, extending vertically through the FEOL region 204, and ending at the embedded die interconnect traces 212 of the BEOL region 202. The plurality of cavities 402 may be etched by way of one or more suitable etch processes, for example. In some embodiments, the embedded die interconnect traces 212 may serve as etch stops preventing the etch from progressing further into the BEOL region 202. As a result of forming the cavities 402, portions of the embedded die interconnect traces 212 are exposed from the backside of the semiconductor die 102. Each cavity 402 is formed to have predetermined diameter and depth dimensions. The predetermined dimensions of the cavities 402 are chosen to accommodate respective die connectors (e.g., copper pillars, stud bumps) for interconnection of a second semiconductor die or other component mounted within the cavity at a subsequent stage of manufacture.

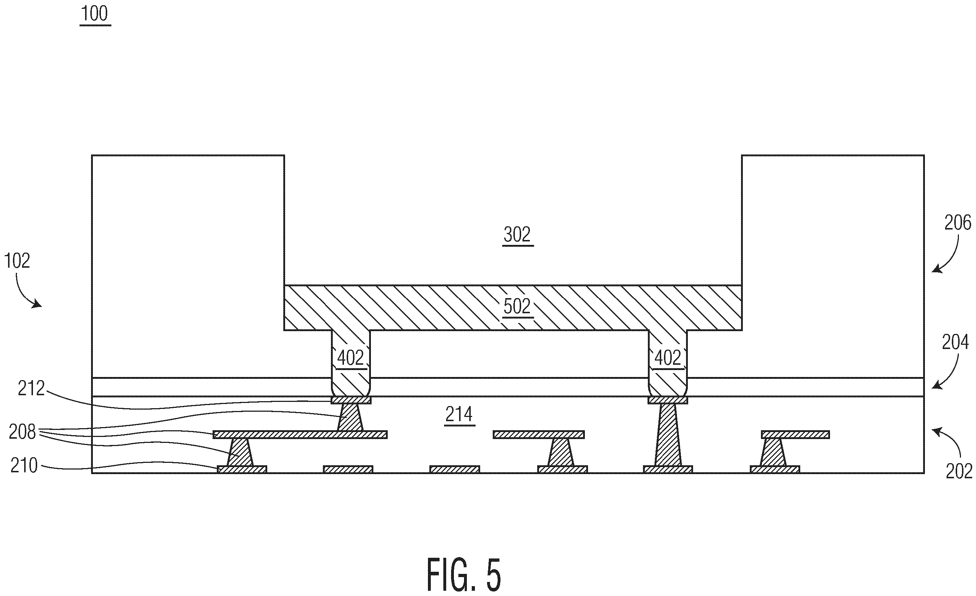

FIG. 5 illustrates, in a simplified cross-sectional view, the example die-in-die semiconductor device 100 at a subsequent stage of manufacture in accordance with an embodiment. At this stage, the semiconductor device 100 includes a thermal compression non-conductive paste (TCNCP) material 502 formed at the bottom side of the first cavity 302. In this embodiment, the TCNCP material 502 is dispensed into the first cavity 302 and second cavities 402. The dispensed TCNCP material 502 substantially fills the cavities 402 and covers the bottom surface of the cavity 302. In this embodiment, the TCNCP material 502 remains uncured until after a second semiconductor die or other component is mounted within the cavity at a subsequent stage of manufacture.

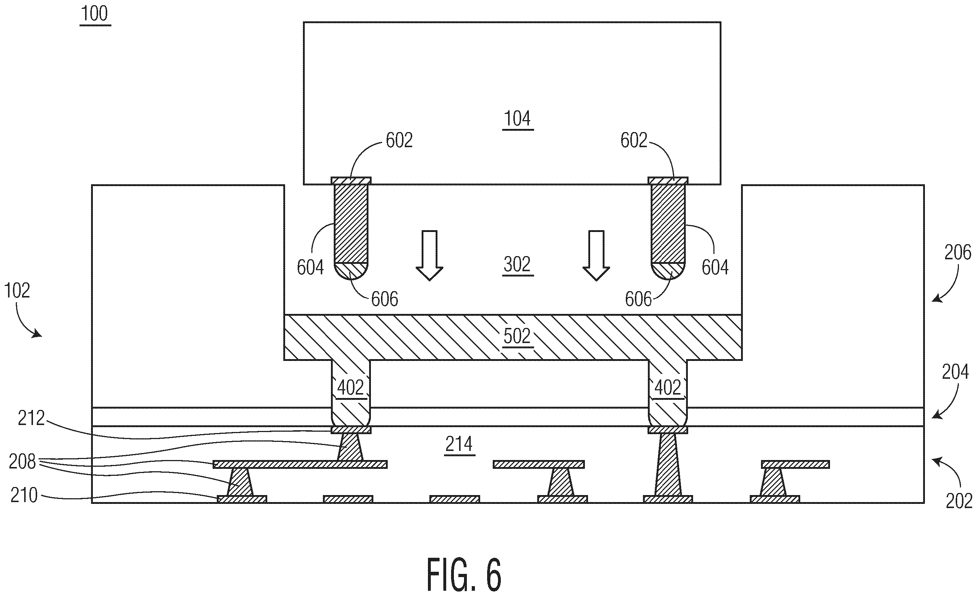

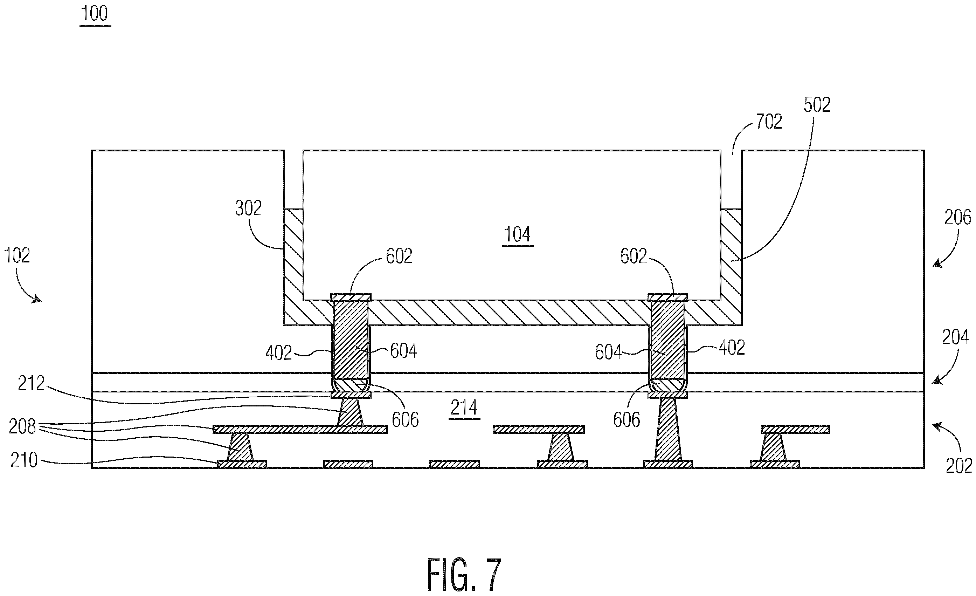

FIG. 6 and FIG. 7 illustrate, in simplified cross-sectional views, the example die-in-die semiconductor device 100 at a subsequent stage of manufacture in accordance with an embodiment. As depicted in FIG. 6, the second semiconductor die 104 is positioned and aligned for mounting with the first cavity 302. In this embodiment, the semiconductor die 104 includes bond pads 602 and respective copper pillars 604 affixed to the bond pads 602. In this embodiment, the copper pillars 604 are formed with solder tips 606. As depicted by the arrows of FIG. 6, the semiconductor die 104 with copper pillars 604 is inserted into the cavity 302 with a thermal compressive force such that the copper pillars 604 are pushed into respective cavities 402. With the copper pillars 604 pushed into respective cavities 402 as depicted in FIG. 7, the TCNCP material 502 is displaced allowing the tips (e.g., solder tips 606) of the copper pillars 604 to form conductive connections by engaging directly with the respective die interconnect traces 212 of the BEOL region 202 of the first semiconductor die 102.

Concurrently, as the semiconductor die 104 with copper pillars 604 is inserted into the cavity 302 with the thermal compressive force, the active side of the semiconductor die 104 engages with the TCNCP material 502 and further displaces the TCNCP material 502 within the cavity 302. With the TCNCP material 502 further displaced by the inserted semiconductor die 104 with copper pillars 604, the TCNCP material 502 fills the gap formed between the active side of the semiconductor die 104 and the bottom of the cavity 302 and at least partially fills the gap formed between the sidewalls of the semiconductor die 104 and the sidewalls of the cavity 302.

After the semiconductor die 104 with copper pillars 604 is mounted in the cavity 302 and the conductive connections are formed between the copper pillars 604 and respective die interconnect traces 212, the TCNCP material 502 is subjected to a curing process. With the TCNCP material 502 cured, a hermetic seal is formed between the active side of the semiconductor die 104 and the bottom of the cavity 302 and between the sidewalls of the semiconductor die 104 and the sidewalls of the cavity 302. In this embodiment, the backside of the second semiconductor die 104 is substantially coplanar with the backside of the first semiconductor die 102 after the semiconductor die 104 with copper pillars 604 is mounted in the cavity 302 and the TCNCP material 502 is cured. In some embodiments, the backside of the second semiconductor die 104 may not be coplanar with the backside of the first semiconductor die 102 after the semiconductor die 104 with copper pillars 604 is mounted in the cavity 302 and the TCNCP material 502 is cured.

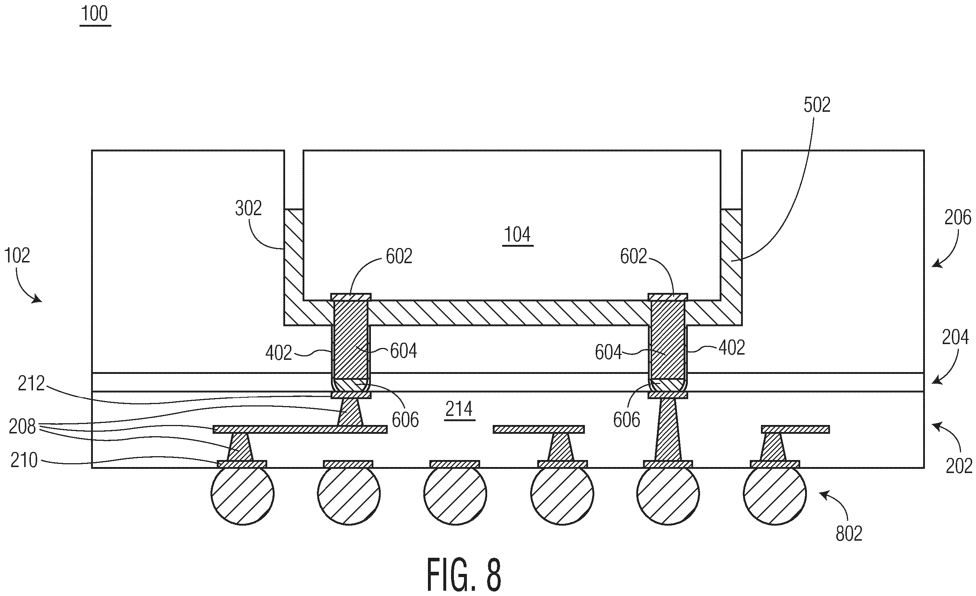

FIG. 8 illustrates, in a simplified cross-sectional view, the example die-in-die semiconductor device 100 at a subsequent stage of manufacture in accordance with an embodiment. At this stage, the semiconductor device 100 includes a plurality of conductive package connectors 802 affixed at the active side of the first semiconductor die 102. In this embodiment, the conductive package connectors 802 are attached to respective package connector pads 210 exposed at the bottom side of the BEOL region 202 of the semiconductor die 102. The conductive connectors 802 are configured to provide a conductive connection between the first semiconductor die 102and a printed circuit board, for example. The conductive connectors 802 may be formed in suitable conductive connector structures such as solder balls, gold studs, copper pillars, and the like. For illustration purposes, the conductive connectors 802 are formed as ball connectors and arranged in a ball grid array.

Generally, there is provided, a method including forming a first cavity in a backside of a first semiconductor die, the first semiconductor die having a back end of line (BEOL) region, a front end of line (FEOL) region, and a bulk region; and mounting a second semiconductor die in the first cavity, a bond pad of the second semiconductor die interconnected through a bottom side of the first cavity with an embedded conductive trace of the BEOL region of the first semiconductor die. The method may further include forming a second cavity in the backside of the first semiconductor die, the second cavity beginning at the bottom side of the first cavity, extending vertically through the FEOL region, and ending at the embedded conductive trace of the BEOL region of the first semiconductor die. The mounting the second semiconductor die in the first cavity may further include inserting a copper pillar affixed to the bond pad of the second semiconductor into the second cavity to interconnect the bond pad with the embedded conductive trace of the BEOL region of the first semiconductor die. The method may further include dispensing a thermal compression non-conductive paste (TCNCP) material at the bottom side of the first cavity before mounting the second semiconductor die in the first cavity. The TCNCP material may at least partially fill a gap region between sidewalls of the second semiconductor die and sidewalls of the first cavity after mounting the second semiconductor die in the first cavity. The second semiconductor die in the first cavity may further include applying a compressive force between the second semiconductor die and the first semiconductor die to interconnect the second semiconductor die with the embedded conductive trace of the BEOL region of the first semiconductor die. The forming the first cavity in the backside of the first semiconductor die may include forming the first cavity by way of a dry etch. A backside of the second semiconductor die and the backside of the first semiconductor die may be substantially coplanar after mounting the second semiconductor die in the first cavity. The method may further include affixing a plurality of conductive package connectors at an active side of the first semiconductor die.

In another embodiment, there is provided, a semiconductor device including a first semiconductor die, the first semiconductor die having a back end of line (BEOL) region, a front end of line (FEOL) region, and a bulk region; a first cavity formed in a backside of the first semiconductor die; a second semiconductor die mounted in the first cavity, a bond pad of the second semiconductor die interconnected through a bottom side of the first cavity with an embedded conductive trace of the BEOL region of the first semiconductor die. The device may further include a second cavity formed in the backside of the first semiconductor die, the second cavity beginning at the bottom side of the first cavity, extending vertically through the FEOL region, and ending at the embedded conductive trace of the BEOL region of the first semiconductor die. The device may further include a copper pillar affixed to the bond pad of the second semiconductor and a solder-capped portion of the copper pillar affixed to the embedded conductive trace of the BEOL region of the first semiconductor die, the copper pillar at least partially disposed within the second cavity and configured to interconnect the bond pad with the embedded conductive trace. The device may further include a thermal compression non-conductive paste (TCNCP) material disposed in a gap between the bottom side of the first cavity and an active side of the second semiconductor, the TCNCP material configured to completely fill the gap. A backside of the second semiconductor die and the backside of the first semiconductor die are substantially coplanar. The device may further include a plurality of conductive package connectors affixed at an active side of the first semiconductor die.

In yet another embodiment, there is provided, a method including forming a first cavity in a backside of a first semiconductor die, the first semiconductor die having a back end of line (BEOL) region, a front end of line (FEOL) region, and a bulk region; and mounting a second semiconductor die in the first cavity, the second semiconductor die having a backside and an active side, a bond pad at the active side of the second semiconductor die interconnected through a bottom side of the first cavity with an embedded conductive trace of the BEOL region of the first semiconductor die. The method may further include forming a second cavity in the backside of the first semiconductor die, the second cavity beginning at the bottom side of the first cavity, extending vertically through the FEOL region, and ending at the embedded conductive trace of the BEOL region of the first semiconductor die. The mounting the second semiconductor die in the first cavity may further include inserting a copper pillar affixed to the bond pad of the second semiconductor into the second cavity to interconnect the bond pad with the embedded conductive trace of the BEOL region of the first semiconductor die. The method may further include dispensing a thermal compression non-conductive paste (TCNCP) material at the bottom side of the first cavity before mounting the second semiconductor die in the first cavity. The TCNCP material may at least partially fill a gap region between sidewalls of the second semiconductor die and sidewalls of the first cavity after mounting the second semiconductor die in the first cavity.

By now, it should be appreciated that there has been provided a die-in-die semiconductor device. The die-in-die semiconductor device includes a first semiconductor die and a second semiconductor die interconnected with the first semiconductor through a backside of the first semiconductor die. A first cavity is formed in the backside of the first semiconductor die. The first cavity has width, length, and depth dimensions sufficient for mounting the second semiconductor die at least partially within the first cavity. A plurality of second cavities is formed in the backside of the first semiconductor die and begin at the bottom side of the first cavity, extend vertically through a front end of line region, and end at embedded die interconnect traces of a back end of line region. A portion of the die interconnect traces are exposed at the bottom of the second cavities. After forming the second cavities, a thermal compression non-conductive paste material (e.g., commonly used in flip-chip packaging) is dispensed at the bottom side of the first cavity such that the second cavities are filled, and the bottom of the first cavity is covered. The second semiconductor die includes a plurality of copper pillar affixed to respective bond pads of the second semiconductor die. The second semiconductor die with copper pillars is inserted into the first cavity with a thermal compressive force such that the copper pillars are pushed into respective second cavities. With the copper pillars pushed into respective cavities, the thermal compression non-conductive paste material is displaced, and conductive connections are formed with the respective die interconnect traces of the first semiconductor die. With the thermal compression non-conductive paste material cured, a hermetic seal is formed in the first cavity between the second semiconductor die and the first semiconductor die. By forming the die-in-die semiconductor device in this manner, a compact interconnect, low-profile stacked die arrangement may be realized.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
forming a first cavity in a backside of a first semiconductor die, the first semiconductor die having a back end of line, BEOL, region, a front end of line, FEOL, region, and a bulk region; and
mounting a second semiconductor die in the first cavity, a bond pad of the second semiconductor die interconnected through a bottom side of the first cavity with an embedded conductive trace of the BEOL region of the first semiconductor die.

2. The method of claim 1, further comprising forming a second cavity in the backside of the first semiconductor die, the second cavity beginning at the bottom side of the first cavity, extending vertically through the FEOL region, and ending at the embedded conductive trace of the BEOL region of the first semiconductor die.

3. The method of claim 2, wherein mounting the second semiconductor die in the first cavity further comprises inserting a copper pillar affixed to the bond pad of the second semiconductor into the second cavity to interconnect the bond pad with the embedded conductive trace of the BEOL region of the first semiconductor die.

4. The method of claim 1, further comprising dispensing a thermal compression non-conductive paste, TCNCP, material at the bottom side of the first cavity before mounting the second semiconductor die in the first cavity.

5. The method of claim 4, wherein the TCNCP material at least partially fills a gap region between sidewalls of the second semiconductor die and sidewalls of the first cavity after mounting the second semiconductor die in the first cavity.

6. The method of claim 1, wherein mounting the second semiconductor die in the first cavity further comprises applying a compressive force between the second semiconductor die and the first semiconductor die to interconnect the the second semiconductor die with the embedded conductive trace of the BEOL region of the first semiconductor die.

7. The method of claim 1, wherein forming the first cavity in the backside of the first semiconductor die includes forming the first cavity by way of a dry etch.

8. The method of claim 1, wherein a backside of the second semiconductor die and the backside of the first semiconductor die are substantially coplanar after mounting the second semiconductor die in the first cavity.

9. The method of claim 1, further comprising affixing a plurality of conductive package connectors at an active side of the first semiconductor die.

10. A method comprising:
forming a first cavity in a backside of a first semiconductor die, the first semiconductor die having a back end of line, BEOL, region, a front end of line, FEOL, region, and a bulk region; and
mounting a second semiconductor die in the first cavity, the second semiconductor die having a backside and an active side, a bond pad at the active side of the second semiconductor die interconnected through a bottom side of the first cavity with an embedded conductive trace of the BEOL region of the first semiconductor die.

11. The method of claim 10, further comprising forming a second cavity in the backside of the first semiconductor die, the second cavity beginning at the bottom side of the first cavity, extending vertically through the FEOL region, and ending at the embedded conductive trace of the BEOL region of the first semiconductor die.

12. The method of claim 11, wherein mounting the second semiconductor die in the first cavity further comprises inserting a copper pillar affixed to the bond pad of the second semiconductor into the second cavity to interconnect the bond pad with the embedded conductive trace of the BEOL region of the first semiconductor die.

13. The method of any of claims 10 to 12, further comprising dispensing a thermal compression non-conductive paste, TCNCP, material at the bottom side of the first cavity before mounting the second semiconductor die in the first cavity.

14. The method of claim 13, wherein the TCNCP material at least partially fills a gap region between sidewalls of the second semiconductor die and sidewalls of the first cavity after mounting the second semiconductor die in the first cavity.
